# EUROPEAN PATENT SPECIFICATION

(11) **EP 4 030 531 B1**
(45) Date of publication and mention of the grant of the patent: **09.12.2026**
(21) Application number: 20871431.1
(22) Date of filing: 02.10.2020
(51) Int. Cl.: H01M 10/48, H02J 7/00

(54) **ESTIMATION DEVICE, ESTIMATION METHOD AND COMPUTER PROGRAM FOR ASSESSING THE FREEZING RISK OF A LEAD-ACID BATTERY**
SCHÄTZVORRICHTUNG, SCHÄTZVERFAHREN UND COMPUTERPROGRAMM ZUR BEURTEILUNG DES GEFRIERRISIKOS EINER BLEIBATTERIE
DISPOSITIF D'ESTIMATION, PROCÉDÉ D'ESTIMATION ET PROGRAMME D'ORDINATEUR POUR ÉVALUER LE RISQUE DE GEL D'UNE BATTERIE AU PLOMB

(30) Priority: 03.10.2019 JP 2019183336
(43) Date of publication of application: 20.07.2022
(73) Proprietor: GS Yuasa International Ltd., Kisshoin, Minami-ku, Kyoto-shi, Kyoto 601-8520 (JP)
(72) Inventor: SEKIYA, Kazuki, Kyoto-shi, Kyoto 601-8520 (JP); OKAMOTO, Naohisa, Kyoto-shi, Kyoto 601-8520 (JP); HAMANO, Yasuyuki, Kyoto-shi, Kyoto 601-8520 (JP); WADA, Hidetoshi, Kyoto-shi, Kyoto 601-8520 (JP)
(74) Representative: Isarpatent
(86) International application number: PCT/JP2020/037502
(87) International publication number: WO 2021/066127

(56) References cited:
- JP-A- 2017 188 277
- JP-A- 2017 188 277
- JP-A- H06 233 466
- JP-A- H06 233 466

## Description

### TECHNICAL FIELD

The present invention relates to an estimation device, an estimation method, and a computer program.

### BACKGROUND ART

A lead-acid battery includes a positive electrode plate, a negative electrode plate, an electrolyte solution, and a case for housing these. The positive electrode plate and the negative electrode plate are immersed in the electrolyte solution in the case. Lead-acid batteries are used in various applications such as an in-vehicle application and an industrial application. For example, an in-vehicle lead-acid battery is mounted on a vehicle, and supplies power to in-vehicle equipment (electric load) such as lighting and a car stereo. The lead-acid battery is charged with electricity generated by a generator (alternator) included in the vehicle. For example, an industrial lead-acid battery is used as power supply reduction to an emergency power supply.

Patent Document 1 discloses a power supply system including a lead-acid battery that supplies power to an electric load of a vehicle, an acquisition device that acquires a temperature of the lead-acid battery, and a determination device that determines deterioration of the lead-acid battery based on the acquired temperature. Patent Document 2 provides a fuel injection pump for an internal combustion engine to reduce combustion noise by forming an auxiliary barrel port at the position nearly facing the barrel port of a barrel and forming an upper reverse reed above the inclined groove of a plunger. Patent Document 3 provides a secondary battery state detection device to correctly detect the gelation of an electrolyte solution of a secondary battery.

### PRIOR ART DOCUMENT

### PATENT DOCUMENT

Patent Document 1: JP-A-2019-78571
Patent Document 2: JP H06 233466 A
Patent Document 3: JP 2017/188277 A

### SUMMARY OF THE INVENTION

### PROBLEMS TO BE SOLVED BY THE INVENTION

In the power supply system described in Patent Document 1, the deterioration is determined based on a temperature of a lead-acid battery. However, a freezing risk cannot be estimated for an electrolyte solution of a lead-acid battery.

An object of the present invention is to provide an estimation device, an estimation method, and a computer program capable of estimating a freezing risk in a lead-acid battery.

### MEANS FOR SOLVING THE PROBLEMS

According to the present invention, an estimation device is defined by independent claim 1. The estimation device includes an acquisition unit that acquires current, voltage, and temperature of a lead-acid battery, a data accumulation unit that accumulates an integrated value or a calculated value of the current, voltage, and temperature that are acquired, an identification unit that identifies specific gravity of an electrolyte solution of the lead-acid battery based on history data accumulated in the data accumulation unit, an estimation unit that estimates a freezing risk of the lead-acid battery based on identified specific gravity of an electrolyte solution, and an output unit that outputs an estimation result of the estimation unit.

According to the present invention, an estimation method is provided as defined by independent claim 6. The estimation device includes, by using a computer, acquiring current, voltage, and temperature of a lead-acid battery, accumulating an integrated value or a calculated value of the current, voltage, and temperature that are acquired, identifying specific gravity of an electrolyte solution of the lead-acid battery based on accumulated history data, and estimating a freezing risk of the lead-acid battery based on identified specific gravity of an electrolyte solution.

According to the present invention, a computer program is defined by independent claim 7. The computer program for causing a computer to execute processing of acquiring current, voltage, and temperature of a lead-acid battery, accumulating an integrated value or a calculated value of the current, voltage, and temperature that are acquired, identifying specific gravity of an electrolyte solution of the lead-acid battery based on accumulated history data, and estimating a freezing risk of the lead-acid battery based on identified specific gravity of an electrolyte solution.

### BRIEF DESCRIPTION OF THE DRAWINGS

Fig. 1 is a block diagram explaining a schematic configuration of an estimation system.
Fig. 2 is a perspective view illustrating an external configuration of a lead-acid battery.
Fig. 3 is a cross-sectional view taken along line III-III of Fig. 2.
Fig. 4 is a block diagram explaining an internal configuration of an estimation device.
Fig. 5 is a graph illustrating a relationship between an SOC of a lead-acid battery and the specific gravity of an electrolyte solution.
Fig. 6 is a graph illustrating a relationship between a freezing temperature and the specific gravity of the electrolyte solution.
Fig. 7 is a graph illustrating an example of time transition of the specific gravity and a temperature.
Fig. 8 is a flowchart explaining a procedure of processing executed by the estimation device according to an embodiment.
Fig. 9 is a schematic diagram illustrating a configuration of a learning model according to a second embodiment.
Fig. 10 is a block diagram illustrating a configuration of a server device.
Fig. 11 is a flowchart explaining a generation procedure of a learning model.
Fig. 12 is a flowchart explaining a procedure of estimation processing using the learning model.
Fig. 13 is a schematic diagram illustrating a configuration of the learning model according to a third embodiment.

### MODE FOR CARRYING OUT THE INVENTION

An estimation device includes an acquisition unit that acquires current, voltage, and temperature of a lead-acid battery, a data accumulation unit that accumulates an integrated value or a calculated value of the current, voltage, and temperature that are acquired, an identification unit that identifies specific gravity of an electrolyte solution of the lead-acid battery based on history data accumulated in the data accumulation unit, an estimation unit that estimates a freezing risk of the lead-acid battery based on identified specific gravity of an electrolyte solution, and an output unit that outputs an estimation result of the estimation unit.

According to this configuration, the specific gravity of the electrolyte solution of the lead-acid battery is identified based on the history data accumulated in the data accumulation unit. Since a freezing temperature of a charge solution is determined according to the specific gravity of the electrolyte solution, the freezing risk can be estimated by comparing the freezing temperature with temperature of the lead-acid battery including temperature of an environment in which the lead-acid battery is installed.

The estimation device, in which the identification unit may identify the specific gravity of an electrolyte solution of the lead-acid battery from the history data by using a relationship between an SOC of the lead-acid battery and the specific gravity of the electrolyte solution. According to this configuration, the specific gravity of the electrolyte solution can be identified by using a relationship between an SOC and the specific gravity of the electrolyte solution.

In the estimation device, the estimation unit may estimate a freezing risk of the lead-acid battery by comparing a freezing temperature of an electrolyte solution determined according to the specific gravity of the electrolyte solution with an estimated value of temperature of the lead-acid battery. According to this configuration, a freezing risk of the lead-acid battery can be estimated by comparing a freezing temperature of an electrolyte solution determined according to the specific gravity of the electrolyte solution with an estimated value of temperature of the lead-acid battery.

In the estimation device, the estimation unit may estimate a freezing risk by using a learning model configured to output information regarding a freezing risk of the lead-acid battery in response to input of the history data. According to this configuration, since the freezing risk is estimated by using the learning model, the freezing risk can be accurately estimated.

In the estimation device, the learning model may include an input layer to which the history data is input, an output layer that outputs information on a freezing risk of the lead-acid battery, an intermediate layer in which a relationship between the history data and the freezing risk is learned by using history data of the lead-acid battery and label data indicating whether or not the lead-acid battery is frozen as teacher data, and calculation may be performed in the intermediate layer according to input of history data accumulated in the data accumulation unit, and information on a freezing risk may be output from the output layer. According to this configuration, since the freezing risk is estimated by using the learning model, the freezing risk can be accurately estimated.

An estimation method includes, by using a computer, acquiring current, voltage, and temperature of a lead-acid battery, accumulating an integrated value or a calculated value of the current, voltage, and temperature that are acquired, identifying specific gravity of an electrolyte solution of the lead-acid battery based on accumulated history data, and estimating a freezing risk of the lead-acid battery based on identified specific gravity of an electrolyte solution.

A computer program is a computer program for causing a computer to execute processing of acquiring current, voltage, and temperature of a lead-acid battery, accumulating an integrated value or a calculated value of the current, voltage, and temperature that are acquired, identifying specific gravity of an electrolyte solution of the lead-acid battery based on accumulated history data, and estimating a freezing risk of the lead-acid battery based on identified specific gravity of an electrolyte solution.

### (First Embodiment)

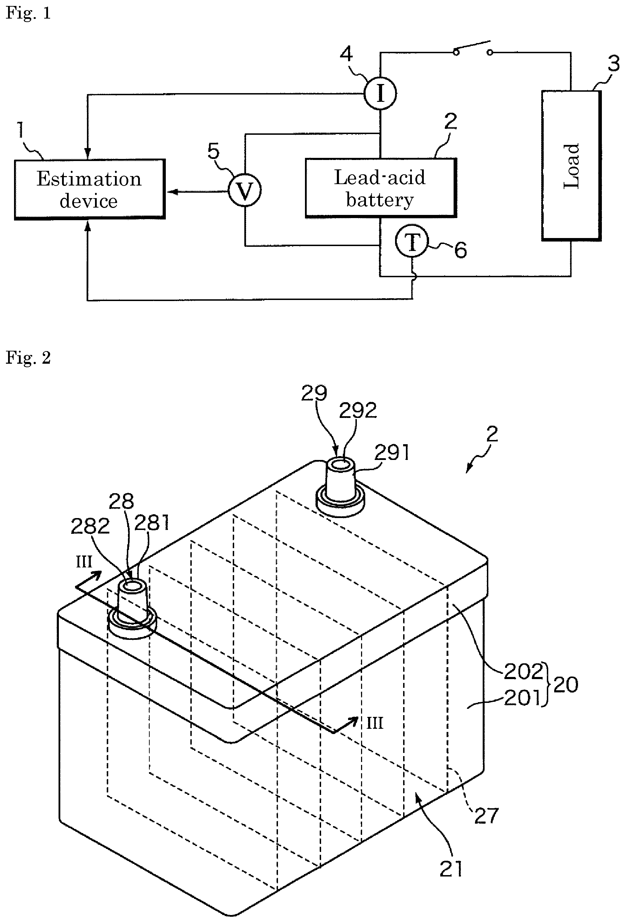

Fig. 1 is a block diagram illustrating a schematic configuration of an estimation system. The estimation system according to a first embodiment includes an estimation device 1 and a lead-acid battery 2. The estimation device 1 is, for example, a battery management unit (BMU), estimates a freezing risk of an electrolyte solution in the lead-acid battery 2 by a method to be described later, and outputs an estimation result. In the example of Fig. 1, the estimation device 1 and the lead-acid battery 2 are described as separate bodies for the sake of convenience. However, the estimation device 1 and the lead-acid battery 2 may be integrated. Furthermore, the estimation device 1 may be an information processing device such as a computer or a server device communicably connected to a battery system including the lead-acid battery 2.

A load 3 is connected to the lead-acid battery 2. The lead-acid battery 2 supplies DC power to the connected load 3. Alternatively, a battery charger (not illustrated) is connected to the lead-acid battery 2. The lead-acid battery 2 stores power by being supplied with DC power from the connected battery charger.

A current sensor 4 measures current flowing through the lead-acid battery 2 in time series, and outputs data indicating a measurement result to the estimation device 1. A voltage sensor 5 measures voltage of the lead-acid battery 2 in time series, and outputs data indicating a measurement result to the estimation device 1. In the present embodiment, the voltage sensor 5 measures an open circuit voltage (OCV) of the lead-acid battery 2. For example, the voltage sensor 5 preferably measures, as an OCV, a voltage value of when the state becomes close to no load. Alternatively, the estimation device 1 may calculate an OCV of the lead-acid battery 2 by calculation based on a current value obtained from the current sensor 4, a voltage value obtained from the voltage sensor 5, and a resistance value of the lead-acid battery 2 measured in advance.

A temperature sensor 6 measures a temperature in time series, and outputs data indicating a measurement result to the estimation device 1. The temperature measured by the temperature sensor 6 may be the temperature of the lead-acid battery 2 or the temperature (air temperature) of an environment in which the lead-acid battery 2 is installed. Furthermore, the estimation device 1 may acquire temperature data of the environment in which the lead-acid battery 2 is installed from an external weather server (not illustrated) instead of the configuration of acquiring temperature data from the temperature sensor 6. In description below, the temperature (temperature of the lead-acid battery 2 or temperature of the installation environment) acquired by the estimation device 1 from the temperature sensor 6 and the temperature acquired by the estimation device 1 from an external weather server are not distinguished and are simply referred to as the temperature of the lead-acid battery 2.

The estimation device 1 estimates the specific gravity of an electrolyte solution in the lead-acid battery 2 based on time-series data of current, voltage, and the temperature of the lead-acid battery 2, and compares a freezing temperature determined according to the specific gravity with the temperature of the lead-acid battery 2 to estimate a freezing risk in the electrolyte solution of the lead-acid battery 2.

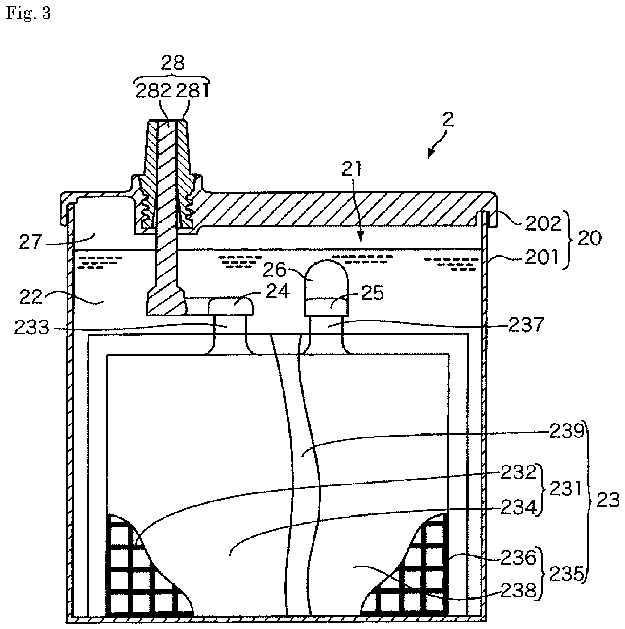

Fig. 2 is a perspective view illustrating an external configuration of the lead-acid battery 2, and Fig. 3 is a cross-sectional view taken along line III-III of Fig. 2. As illustrated in Figs. 2 and 3, the lead-acid battery 2 includes a container 20, a positive electrode terminal 28, a negative electrode terminal 29, and a plurality of elements 23.

The container 20 has a container main body 201 and a lid 202. The container main body 201 is a rectangular parallelepiped container whose upper portion is opened, and is formed of, for example, synthetic resin or the like. For example, the lid 202 made from synthetic resin covers an opening portion of the container main body 201. A peripheral edge portion of a lower surface of the lid 202 and a peripheral edge portion of the opening portion of the container main body 201 are joined by, for example, thermal welding. A space in the container 20 is partitioned by a partition 27 into a plurality of cell chambers 21 arranged in the longitudinal direction of the container 20.

One of the elements 23 is accommodated in each of the cell chambers 21 in the container 20. An electrolyte solution 22 containing dilute sulfuric acid is accommodated in each of the cell chambers 21 in the container 20, and the entire element 23 is immersed in the electrolyte solution 22. The electrolyte solution 22 is injected into the cell chamber 21 from an electrolyte solution filling port (not shown) provided on the lid 202.

The element 23 includes a plurality of positive electrode plates 231, a plurality of negative electrode plates 235, and a separator 239. A plurality of the positive electrode plates 231 and a plurality of the negative electrode plates 235 are alternately arranged.

The positive electrode plate 231 includes a positive electrode grid 232 and a positive electrode material 234 supported by the positive electrode grid 232. The positive electrode grid 232 is a conductive member having a bone portion arranged in a substantially grid shape or a net-like shape, and is formed of, for example, lead or a lead alloy. The positive electrode grid 232 has an ear 233 protruding upward in the vicinity of an upper end. The positive electrode material 234 contains lead dioxide. The positive electrode material 234 may further contain a publicly-known additive.

The negative electrode plate 235 includes a negative electrode grid 236 and a negative electrode material 238 supported by the negative electrode grid 236. The negative electrode grid 236 is a conductive member having a bone portion arranged in a substantially grid shape or a net-like shape, and is formed of, for example, lead or a lead alloy. The negative electrode grid 236 has an ear 237 protruding upward in the vicinity of an upper end. The negative electrode material 238 contains lead. The negative electrode material 238 may further contain a publicly-known additive.

The separator 239 is formed of, for example, an insulating material such as glass or synthetic resin. The separator 239 is interposed between the positive electrode plate 231 and the negative electrode plate 235 adjacent to each other. The separator 239 may be configured as an integral member or may be separately provided between the positive electrode plate 231 and the negative electrode plate 235. Alternatively, the separator 239 may be arranged so as to package either the positive electrode plate 231 or the negative electrode plate 235.

The ears 233 of a plurality of the positive electrode plates 231 are connected to a strap 24 formed of, for example, lead or a lead alloy. A plurality of the positive electrode plates 231 are electrically connected in parallel via the strap 24. Similarly, the ears 237 of a plurality of the negative electrode plates 235 are connected to a strap 25 formed of, for example, lead or a lead alloy. A plurality of the negative electrode plates 235 are electrically connected via the strap 25.

In the lead-acid battery 2, the strap 25 in one of the cell chambers 21 is connected to the strap 24 in a first one of the cell chambers 21 adjacent to the one of the cell chambers 21 via an intermediate pole 26 formed of, for example, lead or a lead alloy. Further, the strap 24 in the one of the cell chambers 21 is connected to the strap 25 in a second one of the cell chambers 21 adjacent to the one of the cell chambers 21 via the intermediate pole 26. That is, a plurality of the elements 23 of the lead-acid battery 2 are electrically connected in series via the straps 24 and 25 and the intermediate pole 26. As illustrated in Fig. 3, the strap 24 accommodated in the cell chamber 21 located at a first end of the container 20 in the longitudinal direction is connected not to the intermediate pole 26 but to a positive pole 282 described later. The strap 25 accommodated in the cell chamber 21 located at a second end of the container 20 in the longitudinal direction is connected not to the intermediate pole 26 but to a negative pole (not illustrated).

The positive electrode terminal 28 is arranged in a first end portion of the container 20 in the longitudinal direction, and the negative electrode terminal 29 is arranged near a second end portion of the container 20 in the longitudinal direction.

As illustrated in Fig. 3, the positive electrode terminal 28 includes a bushing 281 and the positive pole 282. The bushing 281 is a substantially cylindrical conductive member, and is formed of, for example, a lead alloy. A lower portion of the bushing 281 is integrated with the lid 202 by insert molding, and an upper portion of the bushing 281 protrudes upward from an upper surface of the lid 202. The positive pole 282 is a substantially cylindrical conductive member, and is formed of, for example, a lead alloy. The positive pole 282 is inserted into a hole of the bushing 281. An upper end portion of the positive pole 282 is located at substantially the same position as an upper end portion of the bushing 281, and is joined to the bushing 281 by welding, for example. A lower end portion of the positive pole 282 protrudes downward further than a lower end portion of the bushing 281 and further protrudes downward further than a lower surface of the lid 202, and is connected to the strap 24 accommodated in the cell chamber 21 located at one end portion in the longitudinal direction of the container 20. Similarly to the positive electrode terminal 28, the negative electrode terminal 29 includes a bushing 291 and a negative pole 292 (see Fig. 2), and has the same configuration as the positive electrode terminal 28.

A load is connected to the bushing 281 of the positive electrode terminal 28 and the bushing 291 of the negative electrode terminal 29. Power is supplied from the lead-acid battery 2 to the load. That is, the lead-acid battery 2 is discharged. Instead of the load, a battery charger may be connected to the bushing 281 of the positive electrode terminal 28 and the bushing 291 of the negative electrode terminal 29. In this case, the lead-acid battery 2 is charged by power supplied from the battery charger to the lead-acid battery 2.

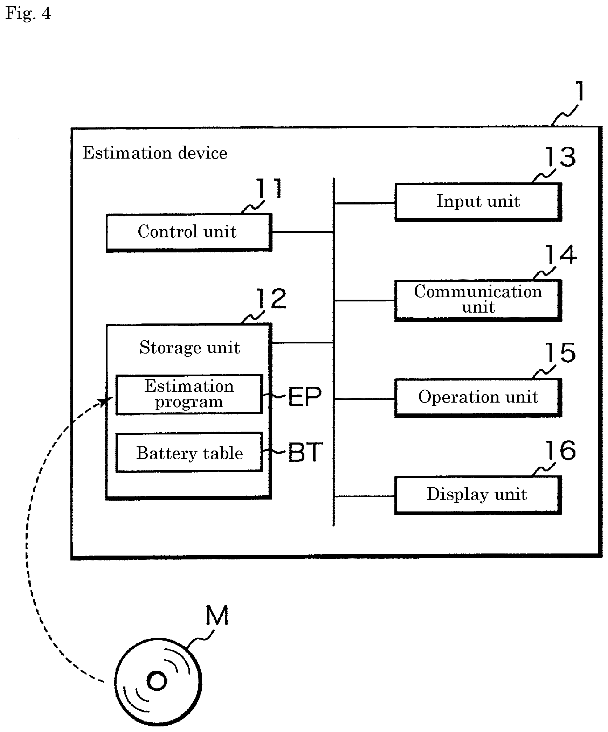

Fig. 4 is a block diagram explaining an internal configuration of the estimation device 1. The estimation device 1 includes a control unit 11, a storage unit 12, an input unit 13, a communication unit 14, an operation unit 15, and a display unit 16.

The control unit 11 includes a central processing unit (CPU), a read only memory (ROM), a random access memory (RAM), and the like. The CPU included in the control unit 11 loads various computer programs stored in the ROM or the storage unit 12 into the RAM and executes them, so as to control operation of the entire device.

The control unit 11 is not limited to the above configuration, and may be any processing circuit or arithmetic circuit including a plurality of CPUs, a multi-core CPU, a graphics processing unit (GPU), a microcomputer, a volatile or nonvolatile memory, and the like. Further, the control unit 11 may have a function of a timer that measures elapsed time from when a measurement start instruction is given to when a measurement end instruction is given, a counter that counts the number, a clock that outputs date and time information, and the like.

The storage unit 12 includes a storage device using a hard disk drive (HDD), a solid state drive (SSD), or the like. The storage unit 12 stores various computer programs executed by the control unit 11, data necessary for executing the computer programs, and the like. The computer program stored in the storage unit 12 includes an estimation program EP for causing the estimation device 1 to execute processing of estimating a freezing risk of the lead-acid battery 2. The estimation program EP may be a single computer program or a program group constituted by a plurality of computers.

The program stored in the storage unit 12 may be provided by a non-transitory recording medium M in which the program is recorded in a readable manner. The recording medium M is, for example, a portable memory such as a CD-ROM, a universal serial bus (USB) memory, a secure digital (SD) card, a micro SD card, and a compact flash (registered trademark). In this case, the control unit 11 reads a program from the recording medium M using a reading device (not illustrated), and installs the read program in the storage unit 12. Further, the program stored in the storage unit 12 may be provided by communication via the communication unit 14. In this case, the control unit 11 acquires the program through the communication unit 14 and installs the acquired program in the storage unit 12.

Furthermore, the storage unit 12 may have a battery table BT that stores information on the lead-acid battery 2. The battery table BT stores, for example, a battery ID for identifying the lead-acid battery 2, a user ID for identifying the user, and battery information in association with each other. The battery information registered in the battery table BT includes, for example, information on a positive electrode and a negative electrode, information on an electrolyte solution, and the like. The information on the positive electrode and the negative electrode is information such as an active material name, thickness, width, depth, and open circuit potential of the positive electrode and the negative electrode. The information on an electrolyte solution is information on an ion species, a transport number, a diffusion coefficient, conductivity, temperature dependency of the specific gravity, and a freezing temperature determined according to the specific gravity. The information stored in the battery table BT is used as a part of parameters when a freezing risk of a power storage device is estimated.

The input unit 13 includes an interface that connects the current sensor 4, the voltage sensor 5, and the temperature sensor 6, and acquires data of current measured by the current sensor 4, voltage measured by the voltage sensor 5, and temperature measured by the temperature sensor 6. In the present embodiment, the current sensor 4, the voltage sensor 5, and the temperature sensor 6 are directly connected to the input unit 13. Alternatively, the estimation device 1 may acquire data of current measured by the current sensor 4, voltage measured by the voltage sensor 5, and temperature measured by the temperature sensor 6 by wired or wireless communication.

The operation unit 15 includes an input interface such as a keyboard and a mouse, and receives operation by the user. The display unit 16 includes a liquid crystal display device and the like, and displays information to be notified to the user. In the present embodiment, the estimation device 1 includes the operation unit 15 and the display unit 16. Alternatively, the configuration may be such that a computer is connected to the outside of the estimation device 1, operation is received through the external computer, and information to be notified is output to the external computer. In this case, the estimation device 1 does not need to include the operation unit 15 and the display unit 16.

The estimation device 1 (1) estimates the specific gravity of an electrolyte solution in the lead-acid battery 2 from time-series data of current and voltage of the lead-acid battery 2, and (2) compares a freezing temperature determined according to the specific gravity with the temperature of the lead-acid battery 2 to estimate a freezing risk in the electrolyte solution of the lead-acid battery 2.

Hereinafter, a method for estimating the specific gravity of the electrolyte solution will be described.

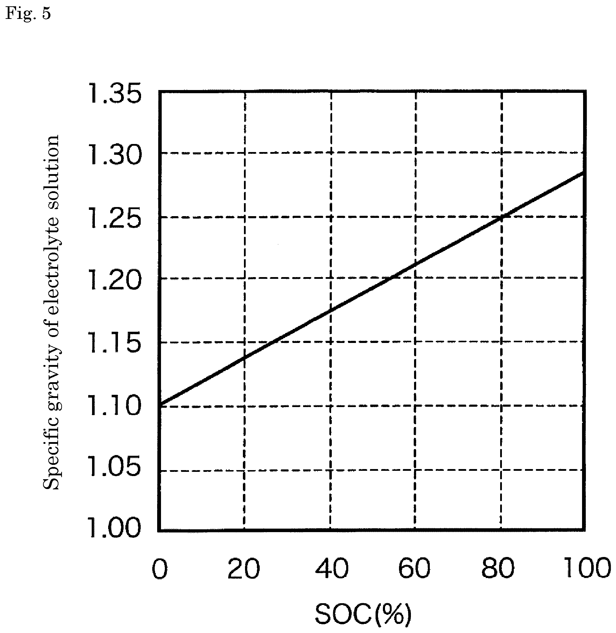

Fig. 5 is a graph illustrating a relationship between an SOC of the lead-acid battery 2 and the specific gravity of the electrolyte solution. The horizontal axis of the graph illustrated in Fig. 5 represents an SOC (%) of the lead-acid battery 2, and the vertical axis represents the specific gravity of the electrolyte solution measured at 20°C. Lead dioxide (PbO₂) is used as a positive active material of the lead-acid battery 2, lead (Pb) in a lattice shape or a net-like shape is used as a negative active material, and sulfuric acid (H₂SO₄) is used as the electrolyte solution. A discharge reaction of the lead-acid battery 2 is expressed as described below.

PbO₂ + Pb + 2HSO₄⁻ + 2H⁺ → 2PbSO₄ + 2H₂O

That is, lead dioxide is changed to lead sulfate and water in the positive electrode, and lead is changed to lead sulfate in the negative electrode. For this reason, as a discharge reaction proceeds, the sulfuric acid concentration in the electrolyte solution decreases. Since there is an excellent correlation between an SOC of the lead-acid battery and the specific gravity of sulfuric acid as the electrolyte solution, the estimation device 1 can estimate the specific gravity of the electrolyte solution from the SOC of the lead-acid battery 2. In the example of Fig. 5, a relationship between the specific gravity of the electrolyte solution at 20°C and the SOC is illustrated. However, the storage unit 12 of the estimation device 1 preferably stores data indicating a relationship between the specific gravity of the electrolyte solution at various temperatures and the SOC.

A publicly-known method is used as an SOC estimation method. For example, the estimation device 1 may be configured to store data of an SOC-OCV characteristic measured in advance in the storage unit 12, and read an SOC corresponding to an OCV from the storage unit 12 every time an OCV is measured. The SOC-OCV characteristic may be given as a table or a function. Alternatively, the estimation device 1 may estimate an SOC by using data of current measured by the current sensor 4, voltage measured by the voltage sensor 5, and the like by simulation using an equivalent circuit model or a physical model of the lead-acid battery 2.

Next, a freezing risk estimation method will be described.

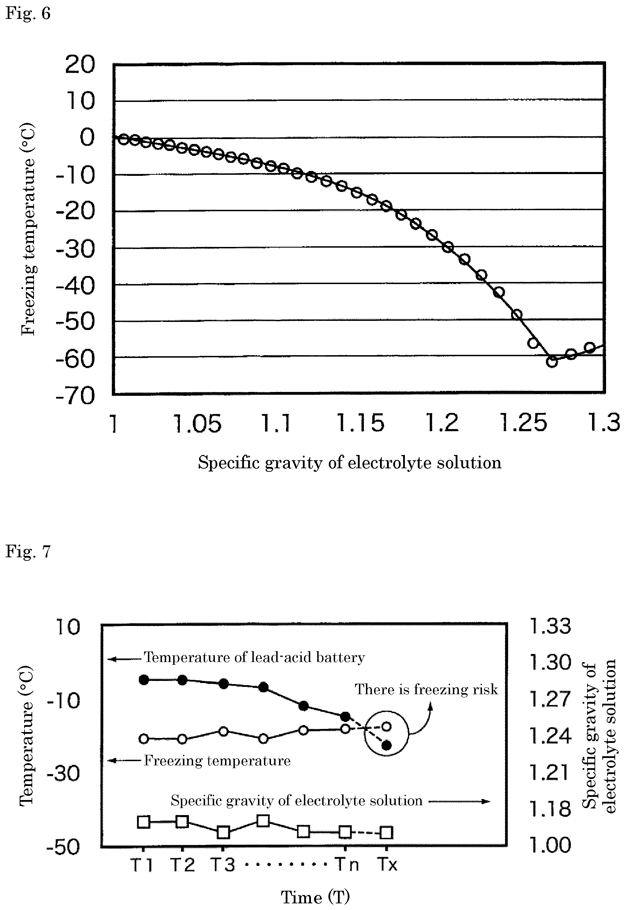

A freezing temperature of the electrolyte solution in the lead-acid battery 2 is determined based on the specific gravity of the electrolyte solution. Fig. 6 is a graph illustrating a relationship between a freezing temperature and the specific gravity of the electrolyte solution. In the graph illustrated in Fig. 6, the horizontal axis represents the specific gravity of the electrolyte solution in the lead-acid battery 2, and the vertical axis represents a freezing temperature (°C) of the electrolyte solution. The graph of Fig. 6 illustrates that a freezing temperature of the electrolyte solution is uniquely determined according to the specific gravity of the electrolyte solution. That is, if the specific gravity of the electrolyte solution in the lead-acid battery 2 can be estimated, the estimation device 1 can obtain a freezing temperature of the electrolyte solution according to the specific gravity. A relationship between the specific gravity of the electrolyte solution and the freezing temperature may be given by a table or a function.

The estimation device 1 can estimate a freezing risk by comparing the obtained freezing temperature of the electrolyte solution with a temperature of the lead-acid battery 2 obtained from the temperature sensor 6 or the like. Fig. 7 is a graph illustrating an example of time transition of the specific gravity and the temperature. The horizontal axis represents time, the left vertical axis represents the temperature (°C), and the right vertical axis represents the specific gravity. The example of Fig. 7 shows a graph obtained by plotting the specific gravity and the freezing temperature of n electrolyte solutions and the temperature of the lead-acid battery 2 from the start of measurement at time T1 to the current time (denoted as Tn).

The control unit 11 estimates a value of the specific gravity at a future time (denoted as Tx) by using values of the specific gravity at the times T1, T2, T3,..., and Tn. Specifically, the control unit 11 may estimate the specific gravity at the time Tx by extrapolating the graph indicating a temporal transition of the specific gravity. As a method of extrapolation, a publicly-known method is preferably used. For example, the control unit 11 preferably expresses the transition of the specific gravity by a function such as a linear function, obtains the function so as to minimize the sum of squares of an error between the function and each measurement value, and obtains the specific gravity at the time Tx by using the obtained function. Instead of the configuration in which the specific gravity at the time Tx is estimated using n pieces of data from the time T1 to the time Tn, the specific gravity at the time Tx may be estimated using latest several pieces of data (for example, the specific gravity at times Tn-2, Tn-1, and Tn).

The control unit 11 estimates a freezing temperature at that time according to the estimated specific gravity at the time Tx. Furthermore, the control unit 11 estimates a temperature of the lead-acid battery 2 at the time Tx. As described above, the control unit 11 may estimate the temperature of the lead-acid battery 2 at the time Tx by extrapolating the graph indicating the temperature transition of the lead-acid battery 2. The control unit 11 may use a forecast value obtained from a weather server or the like instead of an estimated value obtained by calculation.

The control unit 11 estimates a freezing risk by comparing a temperature (estimated value) of the lead-acid battery 2 at the time Tx with a freezing temperature (estimated value) at the time Tx. That is, the control unit 11 preferably determines that there is no freezing risk in a case where the temperature of the lead-acid battery 2 at the time Tx is higher than the freezing temperature at the time Tx, and determines that there is a freezing risk when the temperature of the lead-acid battery 2 at the time Tx is equal to or less than the freezing temperature at the time Tx.

The control unit 11 may estimate the degree of the freezing risk instead of the configuration for estimating the presence or absence of the freezing risk. For example, the control unit 11 may determine the degree of the freezing risk in such a manner that the freezing risk is "small" in a case where the temperature of the lead-acid battery 2 is lower than the freezing temperature by a range of 0°C to 5°C, the freezing risk is "medium" in a case where the temperature of the lead-acid battery 2 is lower than the freezing temperature by a range of 5°C to 10°C, and the freezing risk is "large" in a case where the temperature of the lead-acid battery 2 is lower than the freezing temperature by 10 degrees or more.

Hereinafter, a procedure of processing executed by the estimation device 1 will be described. The estimation device 1 may execute the procedure described below, for example, at a periodic timing, at a timing instructed by the user, at a timing when the outside air temperature falls below a set temperature, or the like.

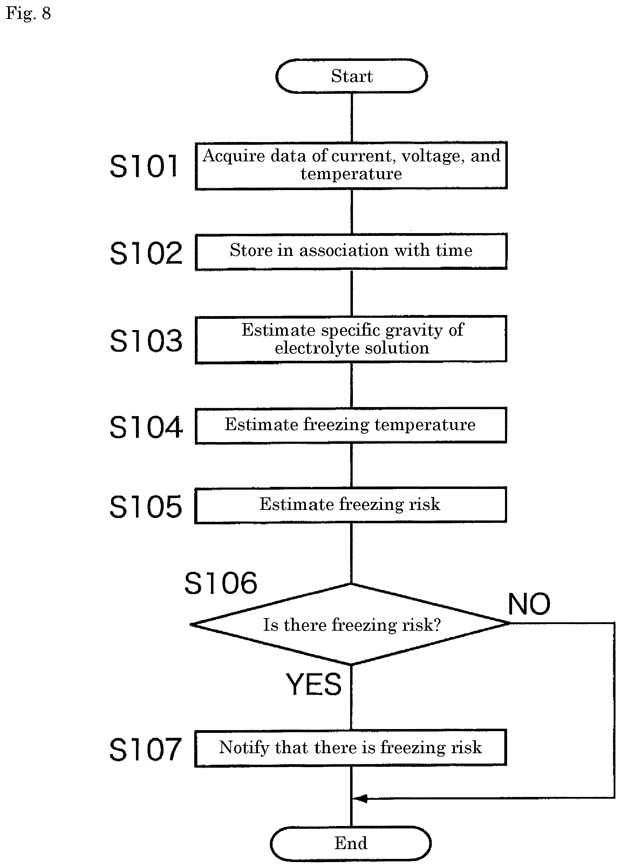

Fig. 8 is a flowchart explaining a procedure of processing executed by the estimation device 1 according to the first embodiment. The control unit 11 of the estimation device 1 acquires data of current measured by the current sensor 4, voltage measured by the voltage sensor 5, and temperature measured by the temperature sensor 6 and the like through the input unit 13 (Step S101). The control unit 11 stores the acquired data in the storage unit 12 as history data in association with time (Step S102). The control unit 11 may store a result of calculation based on the acquired data in association with time.

The control unit 11 estimates the specific gravity of the electrolyte solution based on the data stored in the storage unit 12 (Step S103). The control unit 11 preferably estimates an SOC from a value of the OCV obtained as a measurement result of the voltage sensor 5 and estimates the specific gravity of the electrolyte solution according to the estimated SOC. At this time, the control unit 11 may estimate the specific gravity at a future time (the time Tx in the example of Fig. 7) on the basis of data obtained up to the current time (the time Tn in the example of Fig. 7).

Next, the control unit 11 estimates the freezing temperature based on the specific gravity of the electrolyte solution estimated in Step S103 (Step S104). As described above, since the freezing temperature is determined according to the specific gravity of the electrolyte solution, the control unit 11 can estimate the freezing temperature using a table or a function indicating a relationship between the specific gravity of the electrolyte solution and the freezing temperature.

Next, the control unit 11 estimates a freezing risk (Step S105) and determines whether or not there is a freezing risk (Step S106). At this time, the control unit 11 estimates a freezing risk by comparing an estimated value of temperature of the lead-acid battery 2 at a future time (the time Tx in the example of Fig. 7) estimated from a measurement result of the temperature sensor 6 with the freezing temperature estimated in Step S104. Alternatively, the control unit 11 may estimate the freezing risk by comparing a forecast value of temperature (temperature of an environment where the lead-acid battery 2 is installed) at a future time obtained from a weather server or the like with the freezing temperature estimated in Step S104.

In a case where there is determined to be a freezing risk (S106: YES), the control unit 11 notifies that there is a freezing risk (Step S107). For example, the control unit 11 generates screen data including character information indicating that there is a freezing risk, and causes the display unit 16 to display the character information indicating that there is a freezing risk on the basis of the generated screen data. Alternatively, the control unit 11 may notify a terminal device possessed by the user or the like of the character information indicating that there is a freezing risk through the communication unit 14. In a case where there is determined to be no freezing risk (S106: NO), the control unit 11 ends the processing according to the present flowchart.

As described above, in the first embodiment, the freezing risk in the electrolyte solution can be estimated based on data of current, voltage, temperature, and the like measured for the lead-acid battery 2.

### (Second Embodiment)

In a second embodiment, a configuration for estimating a freezing risk by using a learning model including a neural network will be described.

The estimation device 1 estimates the freezing risk by using a learning model configured to output data on the freezing risk according to the input of data on current, voltage, and temperature of the lead-acid battery 2.

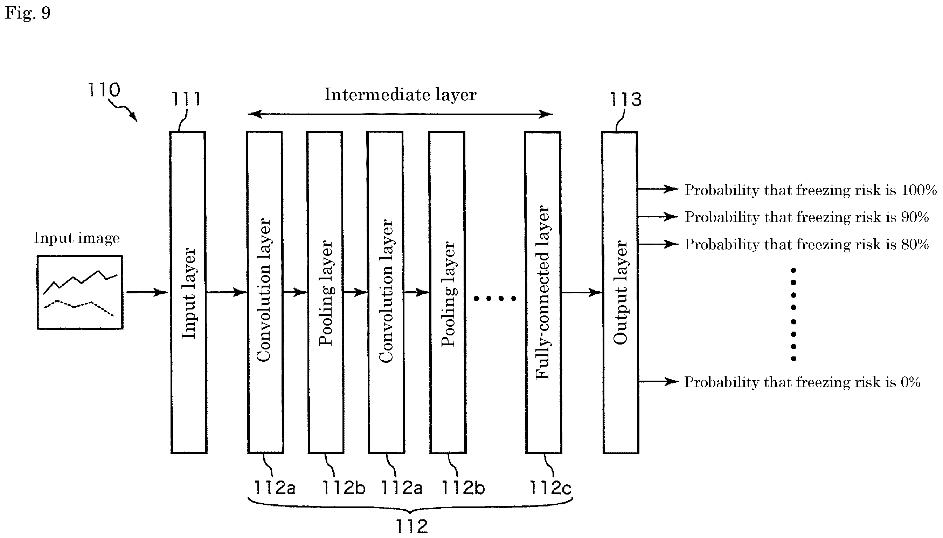

Fig. 9 is a schematic diagram illustrating a configuration of a learning model 110 according to the second embodiment. The learning model 110 in the second embodiment is a learning model based on convolutional neural networks (CNN), region-based CNN (R-CNN), or the like, and includes an input layer 111, an intermediate layer 112, and an output layer 113. The learning model 110 is learned so as to output data regarding the freezing risk with respect to input of a graph (image) indicating a time-series change in current, voltage, temperature, and the like of the lead-acid battery 2. The learning model 110 is generated by, for example, an external server device 100 communicably connected to the estimation device 1, and is stored in the storage unit 12 of the estimation device 1.

In a case of acquiring data of such as current, voltage, temperature, and the like of the lead-acid battery 2, the server device 100 generates a graph illustrating a time-series change of them.

A graph (image) showing time-series changes in current, voltage, temperature, and the like of the lead-acid battery 2 is input to the input layer 111 of the learning model 110.

The intermediate layer 112 includes, for example, a convolution layer 112a, a pooling layer 112b, and a fully-connected layer 112c. A plurality of the convolution layers 112a and a plurality of the pooling layers 112b may be alternately provided. The convolution layer 112a and the pooling layer 112b extract a feature of a graph input through the input layer 111 by calculation using a node of each layer. In the fully-connected layer 112c, data in which a feature portion is extracted by the convolution layer 112a and the pooling layer 112b is connected to one node, and a feature variable converted by an activation function is output. The feature variable is output to the output layer 113 through the fully-connected layer 112c.

The output layer 113 includes one or a plurality of nodes. The output layer 113 converts the characteristic variable input from the fully-connected layer 112c of the intermediate layer 112 into a probability by using a softmax function, and outputs a probability indicating the freezing risk from each node.

For example, the output layer 113 may include eleven nodes from a first node to an eleventh node, and a probability indicating the freezing risk is preferably output from each of the nodes, in such a manner as a probability that the freezing risk is 100% from the first node, a probability that the freezing risk is 90% from the second node,..., and a probability that the freezing risk is 0% from the eleventh node. The number of nodes constituting the output layer 113 and a calculation result assigned to each node are not limited to the above example, and can be appropriately designed.

The control unit 11 of the estimation device 1 can estimate the probability of the freezing risk by referring to a calculation result obtained from the learning model 110 and selecting, for example, a node having a highest probability.

Internal parameters (weight and bias between nodes) defining a configuration of the learning model 110 are learned by using an appropriate learning algorithm in the server device 100, for example.

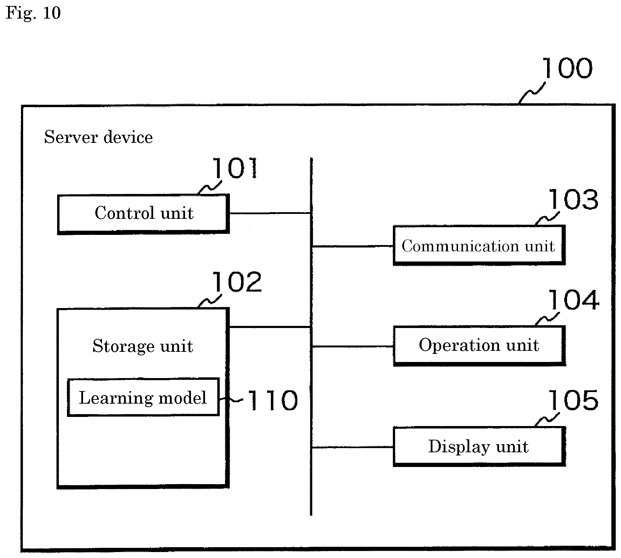

Fig. 10 is a block diagram illustrating a configuration of the server device 100. The server device 100 includes a control unit 101, a storage unit 102, a communication unit 103, an operation unit 104, and a display unit 105.

The control unit 101 includes, for example, a CPU, a ROM, a RAM, and the like. The ROM included in the control unit 101 stores a control program and the like for controlling operation of each unit of hardware included in the server device 100. The CPU in the control unit 101 executes a control program stored in the ROM and various programs stored in the storage unit 102 to control operation of each unit of the hardware.

The control unit 101 is not limited to the above-described configuration. The control unit 101 is not limited to the configuration including the CPU, the ROM, and the RAM. The control unit 101 may be, for example, one or a plurality of control circuits or operation circuits including a GPU, an FPGA, a DSP, a volatile or nonvolatile memory, and the like. Further, the control unit 101 may have a function of a clock that outputs date and time information, a timer that measures elapsed time from when a measurement start instruction is given to when a measurement end instruction is given, a counter that counts the number, and the like.

The storage unit 102 includes a storage device such as a hard disk drive. The storage unit 102 stores various computer programs executed by the control unit 101, various pieces of data used by the computer programs, data acquired from the outside, and the like. An example of the computer program stored in the storage unit 102 is a model generation program for generating the learning model 110. Further, the storage unit 102 may collect data of current, voltage, and temperature from the lead-acid battery 2, and store teacher data including history data including an integrated value or a calculated value and label data indicating whether or not the electrolyte solution of the lead-acid battery 2 is frozen. These pieces of data may be acquired from the estimation device 1 through the communication unit 103.

The communication unit 103 includes a communication interface connected to a communication network. The communication network is an Internet network, an application specific LAN, a wide area network (WAN), or the like. The communication unit 103 transmits data to be transmitted to the estimation device 1 to the estimation device 1 via a communication network. Further, the communication unit 103 receives data transmitted from the estimation device 1 with the server device 100 as a destination via a communication network N.

The operation unit 104 includes an input interface such as a keyboard and a mouse, and receives various types of operation information and setting information. The control unit 101 performs appropriate control on the basis of operation information input from the operation unit 104, and stores setting information in the storage unit 102 as necessary.

The display unit 105 includes a display device such as a liquid crystal display panel or an organic EL display panel, and displays information to be notified to an administrator or the like of the server device 100 on the basis of a control signal output from the control unit 101.

Note that, in the present embodiment, the server device 100 includes the operation unit 104 and the display unit 105. However, the operation unit 104 and the display unit 105 are not essential, and the configuration may be such that operation is received through a computer connected to the outside and information to be notified is output to the external computer.

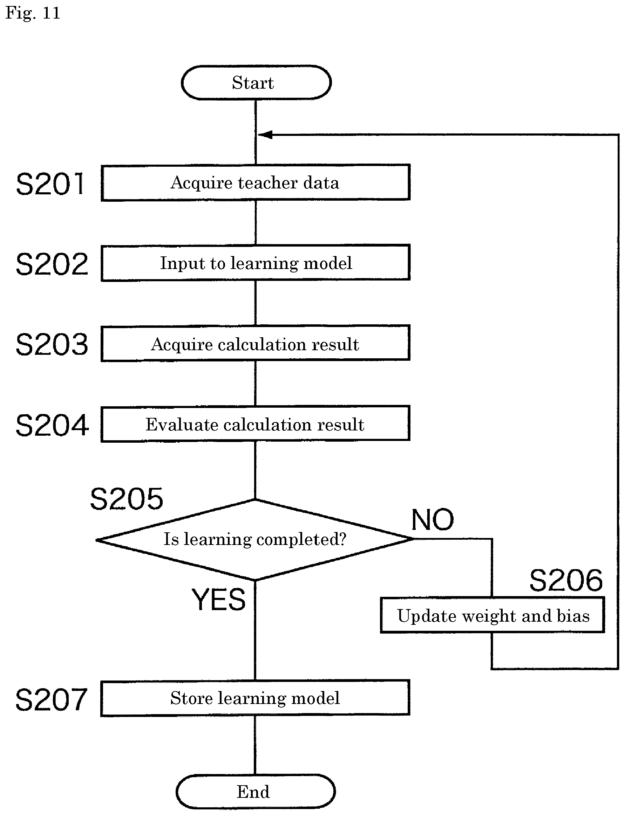

Fig. 11 is a flowchart explaining a generation procedure of the learning model 110. As a preparation stage of generating the learning model 110, the server device 100 collects time series data of current, voltage, and temperature of the lead-acid battery 2 and label data indicating whether or not the lead-acid battery 2 is frozen, and stores the collected data in the storage unit 102 as teacher data. By collecting a sufficient number of time series data and label data at this preparation stage, estimation accuracy of the freezing risk can be enhanced.

The control unit 101 accesses the storage unit 102 and acquires teacher data used for generating the learning model 110 (Step S201). The teacher data includes time series data of current, voltage, and temperature of the lead-acid battery 2 and label data indicating whether or not the lead-acid battery 2 is frozen. In Step S101, one set of time-series data and label data only needs to be acquired from among a large number of time-series data and label data included as teacher data. In an initial stage of generating the learning model 110, teacher data prepared by an administrator or the like of the server device 100 is set. Further, when learning progresses, an estimation result by the learning model 110 and time series data used for estimation processing may be acquired, and the acquired data may be set as teacher data.

Next, the control unit 101 generates a graph (image) from time-series data included as teacher data, inputs the graph (image) to the learning model 110 (Step S202), and acquires a calculation result from the learning model 110 (Step S203). An initial setting value is assumed to be given to definition information describing the learning model 110 before learning is started. In the learning model 110, as described above, predetermined operation is performed between nodes constituting each layer.

Next, the control unit 101 evaluates a calculation result obtained in Step S203 (Step S204), and determines whether or not learning is completed (Step S205). Specifically, the control unit 101 can evaluate a calculation result by using an error function (also referred to as an objective function, a loss function, and a cost function) based on the calculation result obtained in Step S203 and the teacher data. The control unit 101 determines that the learning is completed in a case where an error function is equal to or less than a threshold (or equal to or more than the threshold) in a process of optimizing (minimizing or maximizing) the error function by a gradient descent method such as a steepest descent method. Note that, in order to avoid a problem of over-learning, techniques such as cross-validation and early stopping may be employed to end learning at an appropriate timing.

In a case of determining that the learning is not completed (S205: NO), the control unit 101 updates the weight and bias between the nodes of the learning model 110 (Step S206), and returns the processing to Step S201. The control unit 101 can update the weight and the bias between the nodes by using an error back propagation method of sequentially updating the weight and the bias between the nodes from the output layer 113 to the input layer 111 of the learning model 110.

In a case of determining that the learning is completed (S205: YES), the control unit 101 stores the learned learning model 110 in the storage unit 102 (Step S207), and ends the processing according to the present flowchart.

As described above, the server device 100 can generate the learning model 110 by collecting time series data of current, voltage, and temperature of the lead-acid battery 2 and label data indicating whether or not the lead-acid battery 2 is frozen and using the collected data as teacher data.

The estimation device 1 downloads the learning model 110 generated in the server device 100. The estimation device 1 can estimate the freezing risk of the electrolyte solution in the lead-acid battery 2 by inputting a graph indicating a time-series change in current, voltage, and temperature of the lead-acid battery 2 measured in an operation phase to the learning model 110.

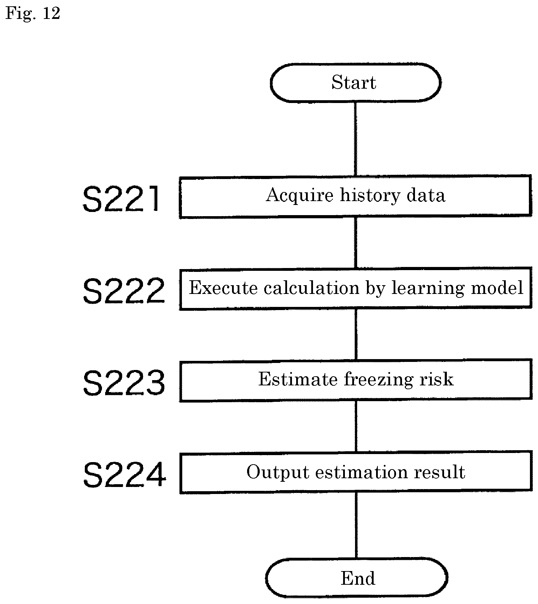

Fig. 12 is a flowchart illustrating a procedure of estimation processing using the learning model 110. The control unit 11 of the estimation device 1 acquires history data regarding current, voltage, and temperature of the lead-acid battery 2 collected in an operation phase from the storage unit 12 (Step S221), and gives image data of a graph generated based on the acquired history data to the learning model 110, so as to execute calculation by the learning model 110 (Step S222). The image data of the graph given to the input layer 111 of the learning model 110 is sent to the intermediate layer 112. In the intermediate layer 112, calculation using an activation function including a weight and a bias between the nodes is executed. In the convolution layer 112a and the pooling layer 112b of the intermediate layer 112, a feature of the image is extracted. Data of a feature portion extracted by the convolution layer 112a and the pooling layer 112b is connected to each node constituting the fully-connected layer 112c, and is converted into a feature variable by an activation function. The converted feature variable is output to the output layer 113 through the fully-connected layer 112c. The output layer 113 converts the characteristic variable input from the fully-connected layer 112c of the intermediate layer 112 into a probability by using a softmax function, and outputs a probability belonging to each category from each node.

The control unit 11 acquires a calculation result from the learning model 110 and estimates the freezing risk on the basis of the acquired calculation result (Step S223). As described above, a probability related to the freezing risk is output from each node constituting the output layer 113 of the learning model 110. The control unit 11 can estimate the freezing risk on the basis of a probability output from each node of the output layer 113.

The control unit 11 outputs an estimation result of Step S223 (Step S224). For example, the control unit 11 may display information indicating the estimation result on the display unit 16. Alternatively, the control unit 11 may notify a terminal device of the user of information indicating the estimation result through the communication unit 14.

As described above, in the second embodiment, since the learning model 110 is used, the freezing risk can be accurately estimated.

### (Third Embodiment)

In a third embodiment, a configuration for estimating a freezing risk by using another learning model including a neural network will be described.

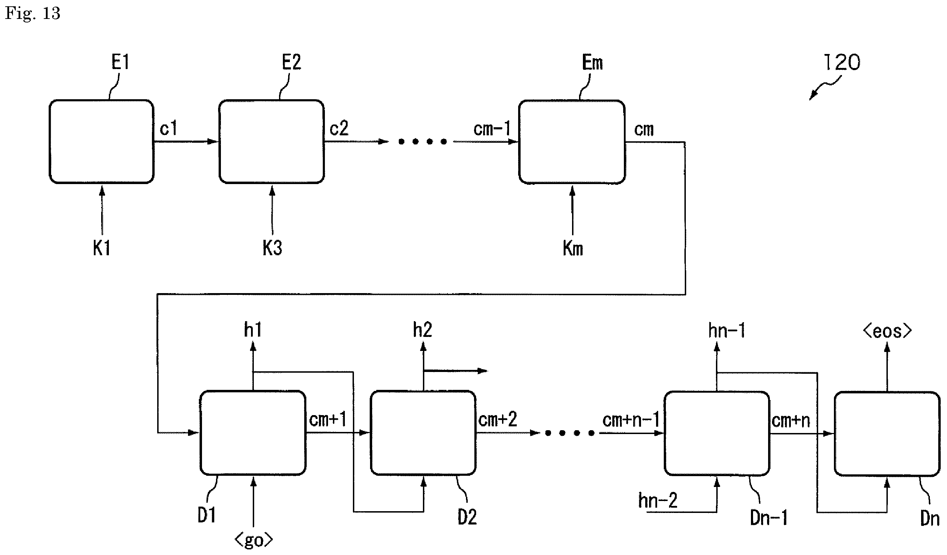

Fig. 13 is a schematic diagram illustrating a configuration of a learning model 120 according to the third embodiment. The learning model 120 according to the third embodiment is a sequence to sequence (seq2seq) model that is a type of a recurrent neural network. The learning model 120 is generated by, for example, the server device 100 and stored in the storage unit 12 of the estimation device 1.

The learning model 120 includes m encoders E1 to Em to which time series data is input and n decoders D1 to Dn that output time series data. The indexes m and n are integers of 2 or more. In Fig. 13, the encoders E1 to Em and the decoders D1 to Dn are described as single blocks, but have a plurality of layers of about two to eight layers including an input layer and a hidden layer. Since an internal structure of the encoders E1 to Em and the decoders D1 to Dn and a method of learning an internal parameter in the encoders E1 to Em and the decoders D1 to Dn are publicly known, detailed description of these will be omitted. In the present embodiment, an internal parameter of the learning model 120 is learned in such a manner that time series data of current, voltage, and temperature of the lead-acid battery 2 is used as input to the learning model 120, and time series data indicating the specific gravity or a freezing temperature is output.

In Fig. 13, the horizontal direction represents a time step, and represents that the procedure is proceeding from the left direction to the right direction in the diagram. Time series data of current, voltage, and temperature of the lead-acid battery 2 is input to each of the encoders E1 to Em.

In a hidden layer of the encoders E1 to Em, the input time-series data is recorded as an internal vector ct as an internal state. Here, t represents a time step, and takes a value of 1 to m in the encoders E1 to Em. The internal vector ct is passed to a value step for each input, and an internal vector cm to be passed to the decoder D1 is obtained when all inputs are completed.

The internal vector cm in the final encoder Em is passed to the decoder D1. A reserved word instructing start of output is input to the decoder D1. In the example of Fig. 13, <go> is described as a reserved word. However, the reserved word only needs to be a preset fixed value. When the internal vector cm is passed from the encoder Em and a reserved word instructing start of output is input, the decoder D1 outputs an output h1, and the internal vector changes to cm+1. The output h1 of the decoder D1 is used as an input to the decoder D2 in a next step. The internal vector cm+1 of the decoder D1 is used as an internal state of the decoder D2 in a next step. In this manner, an output ht of D1, D2,..., and Dn-1 and the internal vector ct are sequentially input to the next decoders D2, D3,..., and Dn, and calculation is sequentially executed until the final decoder Dn outputs a reserved word <eos> indicating the end of the output.

As a result of the above, n-1 obtained outputs h1 to hn-1 of the decoders D1 to Dn-1 are the final outputs of the learning model 120. These outputs h1 to hn-1 represent time-series data indicating the specific gravity or the freezing temperature of the electrolyte solution.

The control unit 11 acquires time-series data indicating the specific gravity or the freezing temperature of the electrolyte solution from the decoders D1 to Dn-1 of the learning model 120. The control unit 11 can sequentially repeat input of time-series data to the encoders E1 to Em and acquisition of time-series data output from the decoders D1 to Dn-1, so as to estimate a temporal change in the specific gravity or the freezing temperature of the electrolyte solution.

The control unit 11 can estimate the freezing risk based on the estimated specific gravity or freezing temperature of the electrolyte solution. That is, in a case of estimating the specific gravity by using the learning model 120, the control unit 11 can estimate the freezing risk by estimating the freezing temperature determined according to the specific gravity and comparing the estimated freezing temperature with temperature of the lead-acid battery 2. Similarly, in a case of estimating the freezing temperature by using the learning model 120, the control unit 11 can estimate the freezing risk by comparing the estimated freezing temperature with temperature of the lead-acid battery 2.

As described above, in the third embodiment, the freezing risk in the electrolyte solution can be estimated based on data of current, voltage, temperature, and the like measured for the lead-acid battery 2.

### DESCRIPTION OF REFERENCE SIGNS

1: estimation device
11: control unit
12: storage unit
13: input unit
14: communication unit
15: operation unit
16: display unit
2: lead-acid battery
3: load
4: current sensor
5: voltage sensor
6: temperature sensor
EP: estimation program

## Claims

1. An estimation device (1) comprising:
an acquisition unit configured to acquire current, voltage, and temperature of a lead-acid battery (2);
a data accumulation unit configured to accumulate an integrated value or a calculated value of the current, voltage, and temperature that are acquired;
an identification unit configured to identify specific gravity of an electrolyte solution of the lead-acid battery (2) based on history data accumulated in the data accumulation unit;
an estimation unit configured to estimate a freezing risk of the lead-acid battery (2) based on identified specific gravity of an electrolyte solution; and
an output unit configured to output an estimation result of the estimation unit.

2. The estimation device (1) according to claim 1, wherein
the identification unit is configured to identify specific gravity of an electrolyte solution of the lead-acid battery (2) from the history data by using a relationship between an SOC of the lead-acid battery and the specific gravity of the electrolyte solution.

3. The estimation device (1) according to claim 1 or 2, wherein
the estimation unit is configured to estimate a freezing risk of the lead-acid battery (2) by comparing a freezing temperature of an electrolyte solution determined according to the specific gravity of the electrolyte solution with an estimated value of temperature of the lead-acid battery (2).

4. The estimation device (1) according to any one of claims 1 to 3, wherein
the estimation unit is configured to estimate a freezing risk by using a learning model (110) configured to output information regarding a freezing risk of the lead-acid battery (2) in response to input of the history data.

5. The estimation device (1) according to claim 4, wherein
the learning model (110) includes:
an input layer to which the history data is input;
an output layer configured to output information on a freezing risk of the lead-acid battery (2); and
an intermediate layer in which a relationship between the history data and the freezing risk is learned by using history data of the lead-acid battery (2) and label data indicating whether or not the lead-acid battery (2) is frozen as teacher data, wherein
calculation is performed in the intermediate layer according to input of history data accumulated in the data accumulation unit, and information on a freezing risk is output from the output layer.

6. An estimation method comprising:
by using a computer,
acquiring current, voltage, and temperature of a lead-acid battery (2);
accumulating an integrated value or a calculated value of the current, voltage, and temperature that are acquired;
identifying specific gravity of an electrolyte solution of the lead-acid battery (2) based on accumulated history data; and
estimating a freezing risk of the lead-acid battery (2) based on identified specific gravity of an electrolyte solution.

7. A computer program for causing a computer to execute processing of:
acquiring current, voltage, and temperature of a lead-acid battery (2);
accumulating an integrated value or a calculated value of the current, voltage, and temperature that are acquired;
identifying specific gravity of an electrolyte solution of the lead-acid battery (2) based on accumulated history data; and
estimating a freezing risk of the lead-acid battery (2) based on identified specific gravity of an electrolyte solution.

## Patentansprüche

1. Schätzungsvorrichtung (1), umfassend:
eine Erfassungseinheit, die dazu eingerichtet ist, einen Strom, eine Spannung und eine Temperatur einer Blei-Säure-Batterie (2) zu erfassen;
eine Datenakkumulationseinheit, die dazu eingerichtet ist, einen integrierten Wert oder einen berechneten Wert des Stroms, der Spannung und der Temperatur, die erfasst werden, zu akkumulieren;
eine Identifizierungseinheit, die dazu eingerichtet ist, die relative Dichte einer Elektrolytlösung der Blei-Säure-Batterie (2) auf der Grundlage von in der Datenakkumulationseinheit akkumulierten historischen Daten zu identifizieren;
eine Schätzungseinheit, die dazu eingerichtet ist, ein Einfrierrisiko der Blei-Säure-Batterie (2) auf der Grundlage der identifizierten Dichte einer Elektrolytlösung zu schätzen; und
eine Ausgabeeinheit, die dazu eingerichtet ist, ein Schätzungsergebnis der Schätzungseinheit auszugeben.

2. Schätzungsvorrichtung (1) nach Anspruch 1, wobei
die Identifizierungseinheit dazu eingerichtet ist, die relative Dichte einer Elektrolytlösung der Blei-Säure-Batterie (2) anhand der historischen Daten unter Verwendung einer Beziehung zwischen einem SOC der Blei-Säure-Batterie und der relativen Dichte der Elektrolytlösung zu identifizieren.

3. Schätzungsvorrichtung (1) nach Anspruch 1 oder 2, wobei
die Schätzungseinheit dazu eingerichtet ist, ein Einfrierrisiko der Blei-Säure-Batterie (2) durch Vergleichen einer gemäß der relativen Dichte der Elektrolytlösung bestimmten Einfriertemperatur der Elektrolytlösung mit einem geschätzten Temperaturwert der Blei-Säure-Batterie (2) zu schätzen.

4. Schätzungsvorrichtung (1) nach einem der Ansprüche 1 bis 3, wobei
die Schätzungseinheit dazu eingerichtet ist, ein Einfrierrisiko unter Verwendung eines Lernmodells (110) zu schätzen, das dazu eingerichtet ist, in Reaktion auf die Eingabe der historischen Daten Informationen bezüglich eines Einfrierrisikos der Blei-Säure-Batterie (2) auszugeben.

5. Schätzungsvorrichtung (1) nach Anspruch 4, wobei
das Lernmodell (110) aufweist:
eine Eingabeschicht, in die die historischen Daten eingegeben werden;
eine Ausgabeschicht, die dazu eingerichtet ist, Informationen über ein Einfrierrisiko der Blei-Säure-Batterie (2) auszugeben; und
eine Zwischenschicht, in der eine Beziehung zwischen den historischen Daten und dem Einfrierrisiko unter Verwendung von historischen Daten der Blei-Säure-Batterie (2) und von Kennzeichnungsdaten, die angeben, ob die Blei-Säure-Batterie (2) eingefroren ist oder nicht, als Lehrdaten erlernt wird, wobei
die Berechnung in der Zwischenschicht gemäß der Eingabe von in der Datenakkumulationseinheit akkumulierten historischen Daten durchgeführt wird und Informationen über ein Einfrierrisiko von der Ausgabeschicht ausgegeben werden.

6. Schätzungsverfahren, umfassend:
unter Verwendung eines Computers,
Erfassen eines Stroms, einer Spannung und einer Temperatur einer Blei-Säure-Batterie (2);
Akkumulieren eines integrierten Wertes oder eines berechneten Wertes des Stroms, der Spannung und der Temperatur, die erfasst werden;
Identifizieren der relativen Dichte einer Elektrolytlösung der Blei-Säure-Batterie (2) auf der Grundlage der akkumulierten historischen Daten; und
Schätzen eines Einfrierrisikos der Blei-Säure-Batterie (2) auf der Grundlage der identifizierten relativen Dichte einer Elektrolytlösung.

7. Computerprogramm, um einen Computer zu veranlassen, folgende Verarbeitung durchzuführen:
Erfassen eines Stroms, einer Spannung und einer Temperatur einer Blei-Säure-Batterie (2);
Akkumulieren eines integrierten Wertes oder eines berechneten Wertes des Stroms, der Spannung und der Temperatur, die erfasst werden;
Identifizieren der relativen Dichte einer Elektrolytlösung der Blei-Säure-Batterie (2) auf der Grundlage der akkumulierten historischen Daten; und
Schätzen eines Einfrierrisikos der Blei-Säure-Batterie (2) auf der Grundlage der identifizierten relativen Dichte einer Elektrolytlösung.

## Revendications

1. Dispositif d'estimation (1) comprenant :
une unité d'acquisition configurée pour acquérir un courant, une tension une température d'une batterie au plomb-acide (2) ;
une unité d'accumulation de données configurée pour accumuler une valeur intégrée ou une valeur calculée du courant, de la tension et de la température qui sont acquis ;
une unité d'identification configurée pour identifier la densité relative d'une solution électrolytique de la batterie au plomb-acide (2) sur la base de données historiques accumulées dans l'unité d'accumulation de données ;
une unité d'estimation configurée pour estimer un risque de congélation de la batterie au plomb-acide (2) sur la base de la densité identifiée d'une solution électrolytique ; et
une unité de sortie configurée pour fournir en sortie un résultat d'estimation de l'unité d'estimation.

2. Dispositif d'estimation (1) selon la revendication 1, dans lequel
l'unité d'identification est configurée pour identifier la densité relative d'une solution électrolytique de la batterie au plomb-acide (2) à partir des données historiques en utilisant une relation entre un état de charge (SOC) de la batterie au plomb-acide et la densité de la solution électrolytique.

3. Dispositif d'estimation (1) selon la revendication 1 ou 2, dans lequel
l'unité d'estimation est configurée pour estimer un risque de congélation de la batterie au plomb-acide (2) en comparant une température de congélation d'une solution électrolytique déterminée en fonction de la densité de la solution électrolytique avec une valeur estimée de température de la batterie au plomb-acide (2).

4. Dispositif d'estimation (1) selon l'une quelconque des revendications 1 à 3, dans lequel
l'unité d'estimation est configurée pour estimer un risque de congélation en utilisant un modèle d'apprentissage (110) configuré pour fournir en sortie des informations concernant un risque de congélation de la batterie au plomb-acide (2) en réponse à une entrée des données historiques.

5. Dispositif d'estimation (1) selon la revendication 4, dans lequel
le modèle d'apprentissage (110) aufweist :
une couche d'entrée dans laquelle les données historiques sont entrées ;
une couche de sortie configurée pour fournir en sortie des informations sur un risque de congélation de la batterie au plomb-acide (2) ; et
une couche intermédiaire dans laquelle une relation entre les données historiques et le risque de congélation est apprise en utilisant comme données d'apprentissage des données historiques de la batterie au plomb-acide (2) et des données d'étiquette indiquant si la batterie au plomb-acide (2) est congelée ou non, dans lequel
un calcul est effectué dans la couche intermédiaire en fonction de l'entrée de données historiques accumulées dans l'unité d'accumulation de données, et des informations sur un risque de congélation sont fournies en sortie de la couche de sortie.

6. Procédé d'estimation comprenant de :
en utilisant un ordinateur,
acquérir un courant, une tension et une température d'une batterie au plomb-acide (2) ;
accumuler une valeur intégrée ou une valeur calculée du courant, de la tension et de la température qui sont acquis ;
identifier la densité d'une solution électrolytique de la batterie au plomb-acide (2) sur la base de données historiques accumulées ; et
estimer un risque de congélation de la batterie au plomb-acide (2) sur la base de la densité identifiée d'une solution électrolytique.

7. Programme informatique destiné à amener un ordinateur à exécuter un traitement consistant à :
acquérir un courant, une tension et une température d'une batterie au plomb-acide (2) ;
accumuler une valeur intégrée ou une valeur calculée du courant, de la tension et de la température qui sont acquis ;
identifier la densité d'une solution électrolytique de la batterie au plomb-acide (2) sur la base de données historiques accumulées ; et
estimer un risque de congélation de la batterie au plomb-acide (2) sur la base de la densité identifiée d'une solution électrolytique.
